# EUROPEAN PATENT SPECIFICATION

(11) **EP 0 483 408 B1**
(45) Date of publication and mention of the grant of the patent: **08.02.1995**
(21) Application number: 90120994.0
(22) Date of filing: 02.11.1990
(51) Int. Cl.: H05K 3/32, H05K 3/34, H01L 23/48

(54) **Removable VLSI package**
Auswechselbare Höchstintegrationspackung
Empaquetage à très haute intégration amovible

(43) Date of publication of application: 06.05.1992
(73) Proprietor: International Business Machines Corporation, Armonk, N.Y. 10504 (US)
(72) Inventor: Blum, Arnold, Dr. Dipl.-Ing., W-7268 Gechingen (DE); Gerth, Frank, Dipl.-Ing., W-7400 Tübingen (DE); Perske, Manfred, W-7032 Sindelfingen (DE); Schmidt, Manfred, Dipl.-Phys., W-7036 Schönaich (DE)
(74) Representative: Kirchhof, Norbert

(56) References cited:
- DE-A- 2 148 376
- IBM TECHNICAL DISCLOSURE BULLETIN, vol. 18, no. 4, September 1975, pages 1196-1197, New York, US; W. ANACKER: "Miniature pluggable connector using conductive fluid for cryogenic electronic circuits"
- IBM TECHNICAL DISCLOSURE BULLETIN, vol. 25, no. 5, October 1982, page 2568, New York, US; D. GUPTA et al.: "Interface metallurgy for mercury contacts"

## Description

The present invention relates to electronic packages applicable in a removable system having a high contact density. Quite specifically the invention discloses a new packaging system for VLSI semiconductor devices.

In modern VLSI design each integrated circuit carries a plurality of contacts for data I/O transfer, control and timing signals and power supply. With ongoing development of performing higher circuit density the number of necessary contacts per chip increases. In many cases this increased complexity additionally is combined with a scale down of the chip dimensions. Consequently the total area available for interconnections is reduced, leading to a further narrowing of contact pad dimensions respectively. In addition another problem occurs with shrinking of electronic devices. As there is a higher density of current consuming circuits the temperature stresses of the device between duty and standby or power-off cycles are enhanced. This leads to a higher probability of thermomechanically caused damaging of interconnections, thus lowering the lifetime of the package.

Subsequent to device assembly testing of the interconnection quality is applied. If defects are found, rework of the package is necessary, including disassembly, surface cleaning, preparation of contact pads and new bonding.

There are different fabrication techniques for packaging semiconductor devices. Cost and/or performance considerations usually dictate the assembly and packaging details. Most commonly used besides soldering techniques such as the Controlled Collapse Chip Connection (C4) are wire-bonding techniques, i.e. Ultrasonic (U/S), Thermocompression (T/C) and Thermosonic (T/S) Bonding, and the Tape Automated Bonding (TAB).

In the C4 technique pads on the device are carrying solder balls which are melted during an assembly reflow process thus being soldered to the respective contact area of the wiring substrate. For high density devices contacts can be arranged efficiently, e.g. in a square grid array, resulting in the desired amount of interconnections. Especially for such VLSI devices due to the soldering alloy metallurgy thermocycle reliability problems are inherent with C4 techniques. If tested devices show defects and must be removed for rework, C4 soldered devices could only be disassembled performing another heating step for to melt the solder and to pick the device. In this case residuals of solder will remain on all contact areas, which must be removed prior to joining a new device.

Wire bonding is basically a perimeter lead technique as to avoid electrical shorts between the wires. Because of the mechanical process of performing the wire contacts, minimum spacings between the pads are required. Thus only a limited number of contacts is available which in most cases will be insufficient for VLSI devices designed for high-density, large-number interconnections. If rework is necessary, several additional process steps are to perform, which are time consuming and raise the manufacturing costs. Wire bondings are hardly to disconnect precisely and without remaining debris. Each of the wires must be removed, the die debonded, a new device placed and new wires sequentially bonded on the substrate pads that had been previously bonded.

Tape automated bonding similar to wire bonding shows great limitations in the number of contacts that can be bonded. If multi-layer tapes are used to enhance the number of contacts, other problems occur, e.g. warpage of the structure caused by cure-shrinkage of the films. This reduces the practical size of the tape contact pattern. Rework of tape bonded devices is hardly possible due to residual material of the tape and remaining contact metal. IBM Technical Disclosure Bulletin, vol.18, No. 4, Sept. 1975 discloses a package employing cryogenic apparatus.

The present invention as claimed is intended to remedy these drawbacks.

It it thus an object of the invention to disclose a packaging system suitable for high density interconnections.

It is another object of the invention to disclose a system for high density interconnection which could easily be assembled and disassembled.

In the present invention a new type of packaging structure is disclosed, wherein the interconnection between device and wiring substrate combines the features of being easily assembled and disassembled and being suitable for VLSI devices carrying high density contact arrays. For this the interface between substrate and device consists of a plurality of small plug-in connectors. Each single contact is performed by joining two respective parts of connecting means located on the surfaces of the device and the substrate. On one side there are pins or needles and on the other side, as the respective counterparts, there are cavities filled with a conductive liquid or a low melting alloy and sealed with a thin nonconducting foil. During packaging process the tips of the pins or needles penetrate through the foil, thus protruding into the conductive liquid or melted alloy. If disassembling is necessary, the interconnections can easily be separated, whereby the foil holds back the conducting liquid or alloy.

For a better understanding of the present invention together with further objects and advantages, a preferred embodiment of the invention is described in the following with reference to the accompanying drawings, in which:

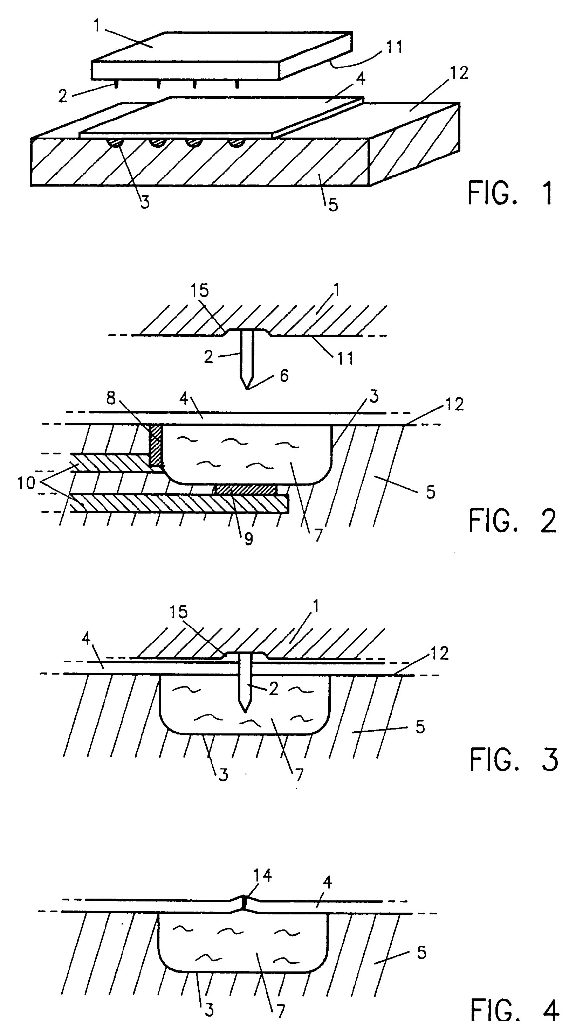

- Figure 1: shows a device carrying connector pins and a substrate having the respective cavities filled with a conducting material and sealed with a thin nonconducting foil;
- Figure 2: illustrates the respective parts of one interconnection prior to assembly;
- Figure 3: is a detail view of one interconnection after the device has been assembled; and
- Figure 4: shows the 'self-healing' effect of the penetrated foil after the device has been removed.

In a preferred embodiment of the invention the contacting surface (11) of an electronic device (1) carries a plurality of pins or needles (2), extending from said contacting surface (11). These pins or needles (2) are contacted to the signal, power supply and all other desired I/O lines of the device and consist of or are covered with metal, metal alloys or doped silicon. Suitable metals and metal alloys are e.g. tungsten, tungsten carbide or copper beryllium but other materials that provide sufficient mechanical stability and minimum current losses could be used. The contact pins (2) are performed e.g. by deposition processes or back-etching of a whole layer of the device (1), whereby defined resistant spots will leave the pins. Due to the different ways of processing the form of the pins can vary, showing e.g. cylindrical, pyramidal or other shapes. To ease penetrating through the foil (4) during assembly, the tips of the pins (6) can be tapered, e.g. by wet etching. In the preferred embodiment of the invention the pins (2) have a mean diameter of about 30 micron and the tip diameter is of about 5 micron, although other values would be suitable. Around the base region of the pins the contact surface (11) of the device (1) is recessed (15) thus giving space for thermal expansion of the conducting material (7) in the cavities (3) after the device was assembled.

On the surface (12) of the counterpart wiring substrate (5) there are holes or cavities (3), which are filled with a conducting material (7) and sealed by a non-conductive foil (4). These cavities could be produced by standard etching processes as known by those skilled in the art of semiconductor technologies. The form of the holes or cavities can vary due to the chosen preparation technique, e.g. anisotropical etching might produce a rather flat bottom with steep sidewalls, whereas wet etching will result in a more rounded shape. If the substrate (5) consists of a crystalline material also crystallographically oriented etching is appropriate, creating cavities having pyramidal forms. The depth of the cavities is at least a bit more than the space needed for the protruding end of the matching pin after assembly. On the bottom and/or at least on parts of the sidewalls of the cavities are conducting lands or pads (8,9) providing electrical contact with the respective wiring lines (10) of the substrate (5). These lands are exposed to the conducting material (7), which thus has the same electrical potential. In the preferred embodiment of the invention the cavity-filling substance (7) consists of a metal alloy having a low melting point, e.g. mercury or eutectic alloys of Al/Bi/Cd/In/Pb/Sn/Zn - known as WOOD alloys, although other materials such as standard solders might be suitable for special applications. The cavity (3) contains the conducting material up to a level next to the surface (12) of the substrate (5). The foil (4) is then deposited onto the whole or only on parts of the substrate surface, so that each cavity and the material therein is hermetically sealed. By this coverage on the one hand corrosion or contamination of the conducting material is prevented on the other hand the conducting material is stripped off from the contact pins (2) during detraction for disassembly of the device. The foil consists of an isolating, elastic substance, e.g. a composition material. Polyester or PVC is preferred, although other nonconducting and flexible materials can be used.

In the presented embodiment the thickness of the foil is chosen equal to or greater than the diameter of the opening that will be caused by the penetrating contact pin (2) during assembly, e.g. for a pin diameter of about 30 micron the foil should have a thickness not less than 30 micron. Due to the elasticity of the foil this ratio will provide a 'self-healing' effect (14) of the foil if the device is disassembled. Other foil materials having other flexibilities could be used with other ratios, including foils being thinner than the diameter of the opening (13).

During assembly the device (1) is positioned above the substrate (5), so that the interconnection surfaces (11,12) are adjusted with respect to the corresponding contact pins (2) and cavities (3). The diameter of the cavities at the level of the substrate surface (12) is preferably several times the diameter of the matching contact pin. This allows a wide range of misalignment. The substrate is held at a temperature at which the conducting material (7) is liquid. The interconnection between device (1) and wiring substrate (5) is then performed by pressing both parts together, whereby the contact pins or needles (2) prick through the foil (4) protruding partly into the conducting material (7) thus being in electrical contact therewith.

The penetration of the contact pins through the foil can be eased by means of ultrasonic vibrations. These vibrations can be generated by at least one external ultrasonic source, e.g. a piezo oscillator. In the preferred embodiment a piezo oscillator is attached to or part of the wiring substrate itself (not shown in the Figures).

If rework is necessary the device (1) could be easily disassembled. For this the substrate (5) is held at or brought to a temperature sufficient for melting said conducting material (7) in said cavities. Then the device can be replaced by simply removing the defect part from the substrate and subsequently attach the new device. Due to the 'self-healing' effect of the covering foil (4), the conducting material remains sufficiently sealed, so that no further process steps like cleaning or preparing of contact means are required. Removing of defect devices therefore could be immediately followed by packaging of another devices.

One of the advantages of the present invention is the stability of the disclosed package against thermostresses. The conducting material (7) can be selected to have a melting point below the operating temperature of the device. As all interconnections are performed by pins or needles penetrating through a flexible foil protruding partly into a liquid conducting material, the respective parts of the interconnection remain movable and can be dislocated in small amounts due to differences in the thermal expansion of the package. Thermal expansion of the conducting material (7) is tolerated because of the free space left by a recessed part (15) around the base of the pins (2). This results in the desired immunity against stresses caused by thermocycles occurring during operation. The same effect can be reached in the case where the conductive material (7) is not liquid during normal operation conditions. If the contact pins (2) have the shape of thin needles and are chosen from materials which posses sufficient mechanical elasticity, this part of the interconnection will follow thermal expansion forces by bending. Damaging of the device or substrate caused by thermally stressed interconnections is thus also avoided or at least significantly reduced.

Although the preferred embodiment of the invention has been described having the contact pins or needles (2) located on the surface (11) of the device (1) and the cavities (3) positioned on the respective side (12) of the wiring substrate (5), it is understood that the corresponding counterparts of the interconnections can be placed vice versa, i.e. the contact pins provided on the surface of the substrate and the cavities on the surface of the device respectively.

## Claims

1. A removable package of at least one electronic device (1) and a wiring substrate (5), comprising at least one pin (2) located on the surface (11) of said electronic device or on the surface (12) of said substrate (5), at least one cavity (3) on the surface (12) of said substrate or on the surface (11) of said device, respectively, located with respect to the corresponding positions of said pin, a low melting point alloy or mercury (7), provided in said cavity and a non-conductive foil (4), covering said cavity and sealing said low melting point alloy or mercury, characterized in that
said foil (4) is elastic and penetrated by said pin (2) thus causing electrical contact between said low melting point alloy (7) or mercury, and said pin (2), whereby said foil (4) has a thickness less or equal to the diameter of the opening (13) caused by said penetration of said pin (2).

2. Method for manufacturing removable packages of the type as recited in claim 1, wherein penetration of said pins (2) through said foil (4) is forced by means of ultrasonic vibrations.

3. Method for manufacturing removable packages according to claim 2, wherein at least one piezo oscillator is used to generate said ultrasonic vibrations.

## Patentansprüche

1. Eine auswechselbare Packung von mindestens einer elektronischen Einheit (1) und einem Leitungssubstrat (5), die mindestens einen Stift (2), der sich auf der Oberfläche (11) der elektronischen Einheit oder auf der Oberfläche (12) des Substrats (5) befindet, mindestens eine Vertiefung (3) auf der Oberfläche (12) des Substrats oder auf der Oberfläche (11) der Einheit, deren Position der Position des Stifts entspricht, eine Legierung mit niedrigem Schmelzpunkt oder Quecksilber (7), die bzw. das sich in der Vertiefung befindet, und eine nicht leitfähige Folie (4), die die Vertiefung bedeckt und die Legierung mit niedrigem Schmelzpunkt oder das Quecksilber versiegelt, umfaßt und dadurch gekennzeichnet ist, daß diese Folie (4) elastisch ist und von dem Stift (2) durchdrungen wird, wodurch ein elektrischer Kontakt zwischen der Legierung mit niedrigem Schmelzpunkt oder dem Quecksilber und dem Stift (2) hergestellt wird, wobei die Folie (4) eine Dicke aufweist, die kleiner ist als der Durchmesser oder identisch ist mit dem Durchmesser der Öffnung (13), die vom Durchdringen des Stifts (2) erzeugt wird.

2. Verfahren zur Herstellung von auswechselbaren Packungen des in Anspruch 1 beschriebenen Typs, wobei das Durchdringen der Stifte (2) durch die Folie (4) durch Ultraschallvibrationen ausgelöst wird.

3. Verfahren zur Herstellung von auswechselbaren Packungen gemäß Anspruch 2, wobei mindestens ein Piezooszillator verwendet wird, um die Ultraschallvibrationen zu erzeugen.

## Revendications

1. Empaquetage amovible d'au moins un dispositif électronique (1) et un substrat de connexion (5), comprenant au moins une broche (2) située sur la surface (11) dudit dispositif électronique ou sur la surface (12) dudit substrat (5), au moins une cavité (3) sur la surface (12) dudit substrat ou sur la surface (11) dudit dispositif, respectivement, située par rapport aux positions correspondantes de ladite broche, un alliage à bas point de fusion ou du mercure (7), fourni dans ladite cavité et une feuille (4) non conductrice couvrant ladite cavité et scellant ledit alliage à bas point de fusion ou mercure, caractérisé en ce que ladite feuille (4) est élastique et pénétrée par ladite broche (2) établissant ainsi le contact électrique entre ledit alliage à bas point de fusion ou mercure (7) et ladite broche (2), de sorte que ladite feuille (4) a une épaisseur inférieure ou égale au diamètre de l'ouverture (13) provoquée par ladite pénétration de ladite broche (2).

2. Méthode pour fabriquer des empaquetages amovibles du type énoncé dans la revendication 1, dans laquelle la pénétration de ladite broche (2) dans ladite feuille (4) est forcée au moyen de vibrations ultrasoniques.

3. Méthode pour fabriquer des empaquetages amovibles selon la revendication 2, dans laquelle au moins un oscillateur piézo est utilisé pour générer lesdites vibrations ultrasoniques.
